# EUROPEAN PATENT SPECIFICATION

(11) **EP 4 191 663 B1**
(45) Date of publication and mention of the grant of the patent: **24.12.2025**
(21) Application number: 22207266.2
(22) Date of filing: 14.11.2022
(51) Int. Cl.: H01L 23/31, H01L 21/56, H10D 62/10, H10D 62/832, H10D 8/60

(54) **METHOD OF MANUFACTURING A SIC-BASED ELECTRONIC DEVICE WITH A PASSIVATION LAYER AND AN ANCHORING ELEMENT AND ELECTRONIC DEVICE MANUFACTURED THEREBY**
VERFAHREN ZUR HERSTELLUNG EINER SIC-BASIERTEN ELEKTRONISCHEN VORRICHTUNG MIT EINER PASSIVIERUNGSSCHICHT UND EINEM VERANKERUNGSELEMENT UND EINER DADURCH HERGESTELLTEN ELEKTRONISCHEN VORRICHTUNG
PROCÉDÉ DE FABRICATION D'UN DISPOSITIF ÉLECTRONIQUE À BASE DE SIC AVEC UNE COUCHE DE PASSIVATION ET UN ÉLÉMENT D'ANCRAGE ET UN DISPOSITIF ÉLECTRONIQUE FABRIQUÉ PAR CELUI-CI

(30) Priority: 26.11.2021 IT 202100029939
(43) Date of publication of application: 07.06.2023
(73) Proprietor: STMicroelectronics S.r.l., 20864 Agrate Brianza (MB) (IT)
(72) Inventor: PUGLISI, Valeria, 95125 CATANIA (IT); BELLOCCHI, Gabriele, 95124 CATANIA (IT); RASCUNA', Simone, 95129 CATANIA (IT)
(74) Representative: Studio Torta S.p.A.

(56) References cited:
- US-A1- 2016 093 748
- US-A1- 2021 104 445
- US-B1- 10 020 373

## Description

The present invention relates to a method of manufacturing an anchoring element of an electronic device, and to an electronic device including the anchoring element. In particular, the anchoring element is designed to improve the reliability of silicon-carbide (SiC) electronic power devices, where the conditions of use envisage high voltages and entail difficulties in forming trenches.

The semiconductor industry has been showing considerable interest in silicon carbide (SiC), in particular for the manufacture of electronic components such as diodes or transistors, above all for power applications.

The electronic devices formed in a silicon-carbide substrate, in its various polytypes (for example, 3C-SiC, 4H-SiC, 6H-SiC), have numerous advantages such present numerous advantages such as low on-state output resistance, low leakage current, resistance to high operating temperatures, and high operating frequencies.

However, the development and manufacture of SiC-based electronic devices are limited by factors such as the electrical and mechanical properties of passivation layers (comprised in these electronic devices and, for example, extending over semiconductor bodies of SiC of the electronic devices). In particular, it is known to produce the passivation layers using polymeric materials (e.g., polyimide) that make it possible to withstand high operating temperatures of the electronic devices and have high dielectric strength, for example, higher than 400 kV/mm. In detail, the high dielectric strength of the polymeric materials guarantees that the passivation layers withstand high electrical fields, and therefore high differences of potential across them, without undergoing electrical breakdown, and therefore without becoming electrically conductive.

However, the polymeric materials have high coefficients of thermal expansion (CTE) (e.g., CTE = 43e⁻⁶ 1/K for the material polybenzobisoxazole, or PIX), and this causes problems of adhesion of the passivation layer to the SiC, which has a lower coefficient of thermal expansion (CTE = 3.8e⁻⁶ 1/K).

In particular, these problems of adhesion between the passivation layer and the SiC may arise during thermal cycling tests (conducted, for example, between approximately -50°C and approximately +150°C) or during use of the electronic device, when the latter is subjected to high thermal swings (e.g., it is subjected to differences of operating temperature equal to, or higher than, approximately 200°C). On account of the large difference in CTE between the passivation layer and the SiC, these high thermal swings generate mechanical stresses at an interface between the passivation layer and the SiC, which can lead to (at least partial) delamination of the passivation layer with respect to the SiC semiconductor body.

In the case where this delamination were to be sufficiently extensive (e.g., such that no portion of the passivation layer is interposed between two metallizations of the electronic device set at different potentials, which are thus separated from one another only by air), electrical discharges may be generated at said interface, leading to damage of the electronic device itself. In particular, the risk of damage of the electronic device increases when the latter is used in reverse-biasing conditions, on account of the high voltage difference (e.g., higher than 1000 V) to be withstood.

Known solutions to this problem comprise the use of a plurality of dielectric layers of materials different from one another (e.g., silicon nitride, silicon oxide, and polyimide in succession to one another) to form a passivation multilayer designed to limit the mechanical stresses at the interface with the SiC semiconductor body.

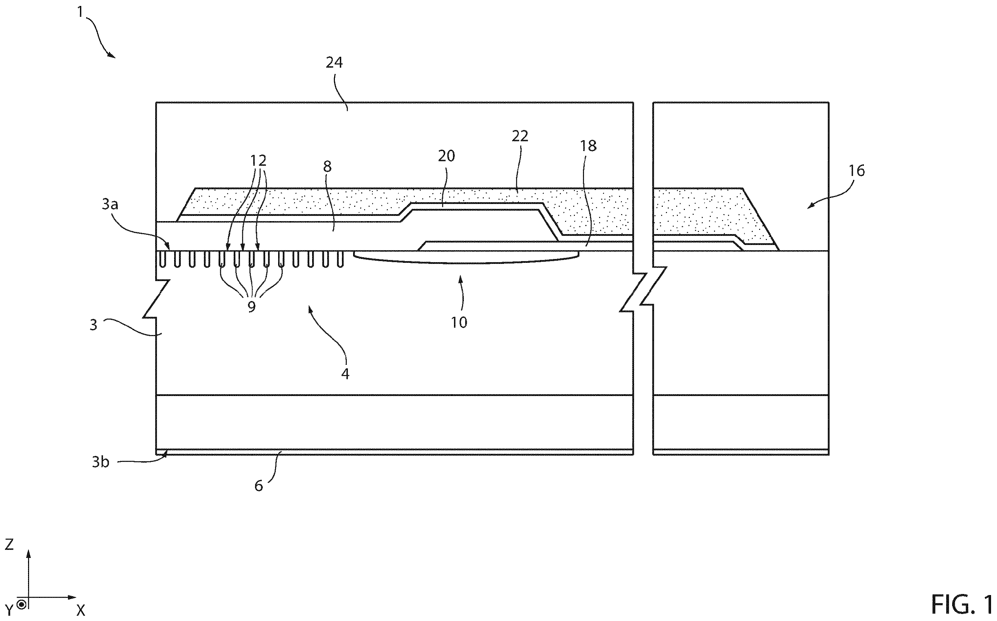

Figure 1 shows, in lateral cross-sectional view in a (triaxial) cartesian reference system of axes X, Y, Z, a portion of an electronic device (here by way of example a JBS or Junction-Barrier Schottky diode) 1 of a known type.

The JBS device 1 comprises a semiconductor body 3, of SiC of an N type, provided with a surface 3a opposite to a surface 3b. The semiconductor body includes, for example, a substrate and one or more regions grown epitaxially on the substrate, of an N type and having respective values of doping concentration. The JBS device 1 further comprises multiple junction-barrier (JB) elements 9 in the semiconductor body 3, facing the top surface 3a and each including a respective implanted region in the semiconductor body 3, of a P type, and an ohmic contact on the implanted region, at the level of the top surface 3a of the semiconductor body 3. The JBS device 1 further comprises a first metallization 8, which extends over the top surface 3a, in electrical contact with the junction-barrier elements 9 through the respective ohmic contacts. The JBS device 1 further comprises an edge-termination region 10 (or protection ring), in particular an implanted region of a P type, which surrounds completely the JB elements 9.

Schottky diodes 12 are formed at the interface between the anode metallization 8 and the semiconductor body 3, where semiconductor-metal Schottky junctions are formed. The region of the MPS device 1 that includes the JB elements 9 and the Schottky diodes 12 (i.e., the region contained within the protection ring 10) is an active area 4 of the JBS device 1.

The JBS device 1 further comprises a second metallization 6, which extends over the bottom surface 3b. The first and the second metallizations 8, 6 form, respectively, electrical anode and cathode terminals, which can be biased during use of the JBS device 1.

An electrically passive region 16 extends outside the edge-termination region 10.

Extending partially over the edge-termination region 10 is an insulating layer 18, of insulating or dielectric material, in particular silicon oxide (SiO₂).

The first metallization 8 is in electrical contact with a portion of the edge-termination region 10, where the latter is not covered by the insulating layer 18, and likewise extends partially over the insulating layer 18. An interface layer 20, here of silicon nitride (SiN), extends over the first metallization 8 and the insulating layer 18. Furthermore, the JBS device 1 comprises a passivation layer 22, in particular of polyimide, which extends over the interface layer 20. In other words, the interface layer 20 serves as interface between the passivation layer 22 and the underlying layers, here the first metallization 8 and the insulating layer 18. The interface layer 20 may be omitted; however, the Applicant has found that the interface layer 20 improves adhesion of the passivation layer 22 to the underlying layers.

A protection layer 24 of a resin, such as bakelite, extends over the passivation layer 22, protecting the JBS device 1 when inserted in a package (not illustrated).

However, even though the interface layer 20 improves, as has been said, adhesion of the passivation layer 22 to the underlying layers, some critical conditions of use or of thermal or thermo-mechanical testing of the JBS device 1 may cause delamination or partial detachment of the passivation layer 22 from the interface layer 20 (on account of the stress generated by the tests). This in particular occurs in conditions of stress caused by high temperatures of use (e.g., above 150°C). This effect, in addition to rendering the JBS device 1 structurally brittle, may be a contributing cause of the occurrence of undesired electrical discharges that affect electrical operation of the JBS device 1. In fact, the Applicant has found that in some process conditions of thermo-mechanical or mechanical stress following upon the assembly process, the interface layer 20 has one or more local cracks throughout its thickness, which, at the first metal layer 8, cause the generation of these electrical discharges. These problems are all the more evident when the electronic device 1 is subjected to high thermal swings and to high voltage differences in reverse-biasing conditions.

Patent application US 2021/104445 relates to a silicon carbide (SiC) power device and manufacturing method thereof, comprising: insulating, metal and passivation layers on a surface of a silicon carbide semiconductor body and an anchoring element protruding from the passivation layer towards the insulating layer that terminates within the insulating layer, wherein the anchoring element has at least one dimension in a direction parallel to the surface of the semiconductor body.

Patent US 10,020,373 relates to the construction of a semiconductor device in which a passivation layer is formed over an electrode.

Patent application US2016/093748 relates to semiconductor devices, and in particular to passivation of such devices.

However, the above-mentioned issues are not solved.

The need is therefore felt to overcome the aforementioned problems.

According to the present invention a method of manufacturing an anchoring element of an electronic device, and an electronic device including the anchoring element are provided, as defined in the annexed claims.

For a better understanding of the present invention, a preferred embodiment thereof is now described, purely by way of non-limiting example, with reference to the attached drawings, wherein:
- Figure 1 illustrates, in a cross-sectional view, an electronic device of a known type;
- Figure 2 illustrates, in a cross-sectional view, an electronic device that is not an embodiment of the present invention, but useful for its understanding;
- Figures 3A and 3B show, in plan view, the electronic device of Figure 2;
- Figure 4 illustrates, in a cross-sectional view, a portion of an electronic that is not an embodiment of the present invention, but useful for its understanding;
- Figures 5A-5C show, in cross-sectional views, steps for manufacturing the electronic device of Figure 2, this method not being an embodiment of the present invention, but useful for its understanding;
- Figure 6 illustrates, in a cross-sectional view, an electronic device according to a first embodiment of the present invention; and
- Figures 7A-7D show, in cross-sectional views, steps for manufacturing the electronic device of Figure 6, according to an embodiment of the present invention and limitedly to the manufacture of an anchoring element.

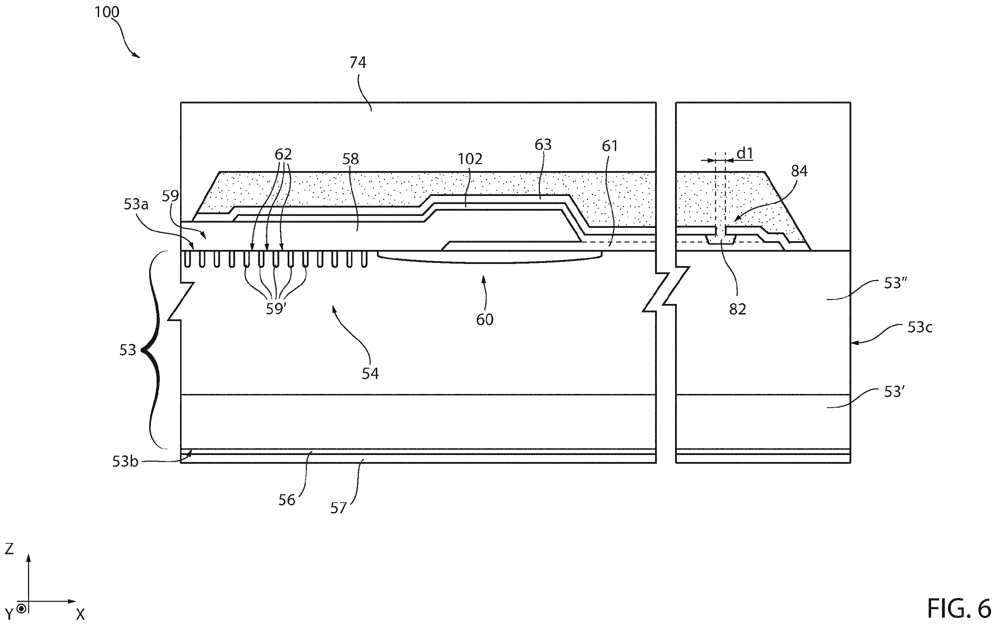

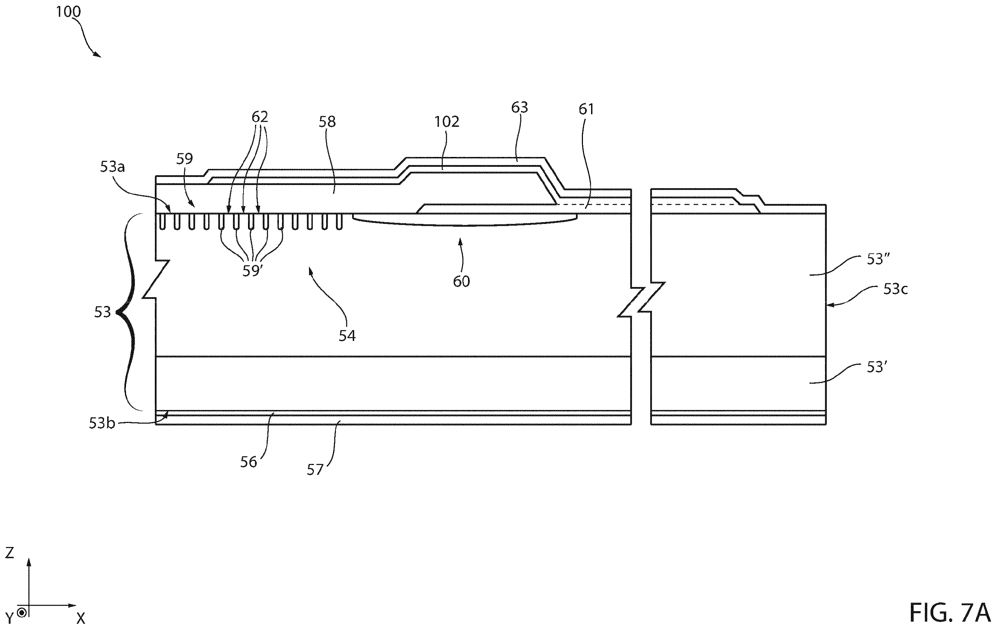

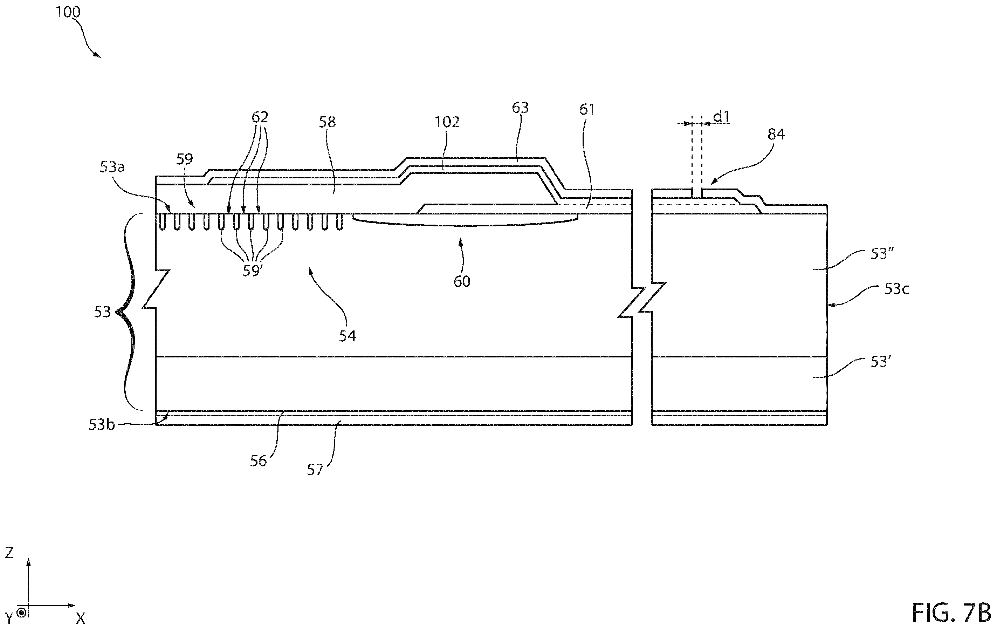

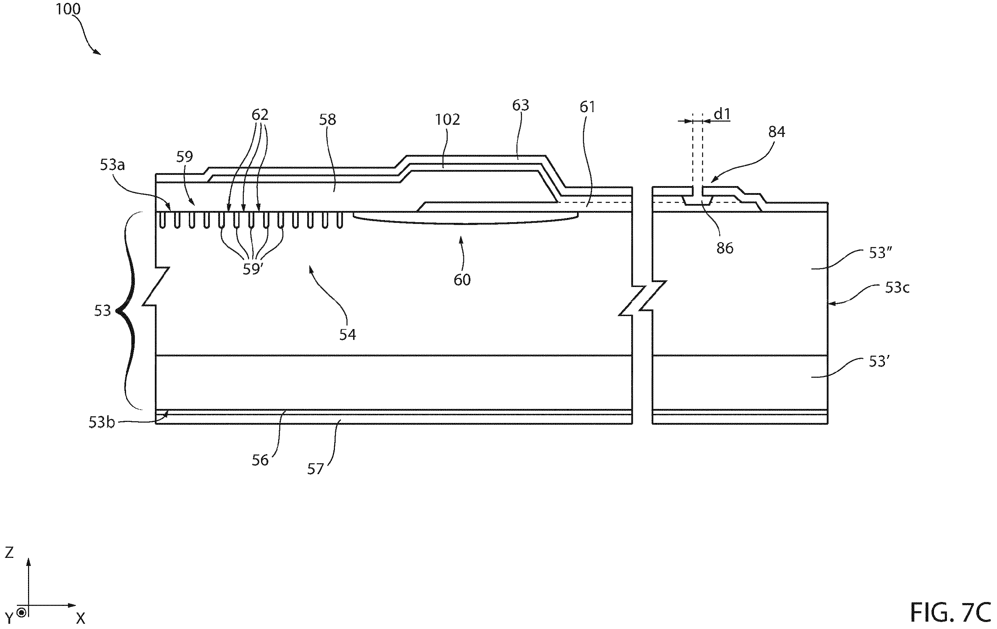

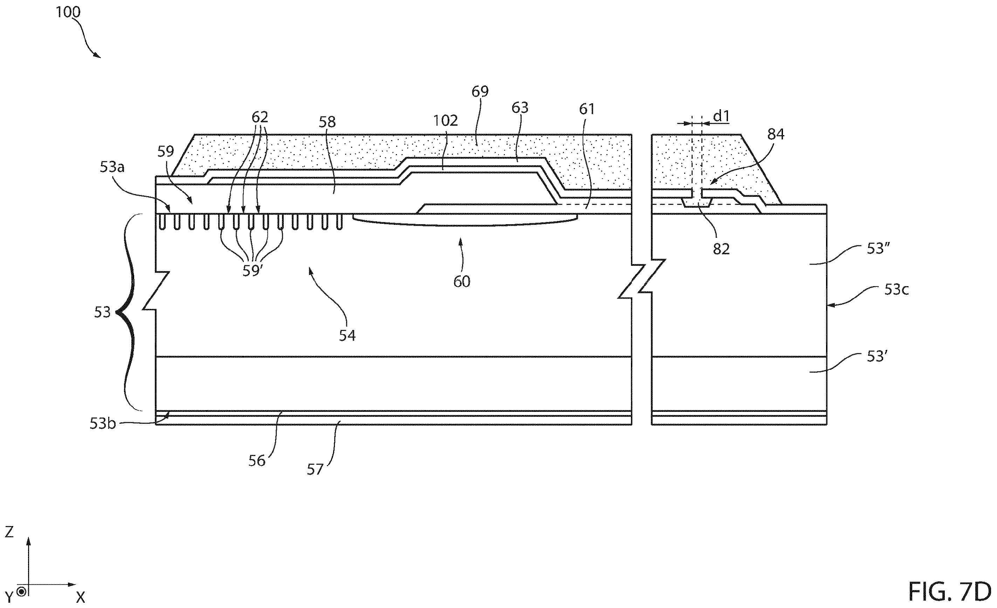

In the following, only the embodiments described with respect to Figures 6 and 7 are embodiments of the present invention. Other embodiments mentioned are examples that are useful for understanding the present invention.

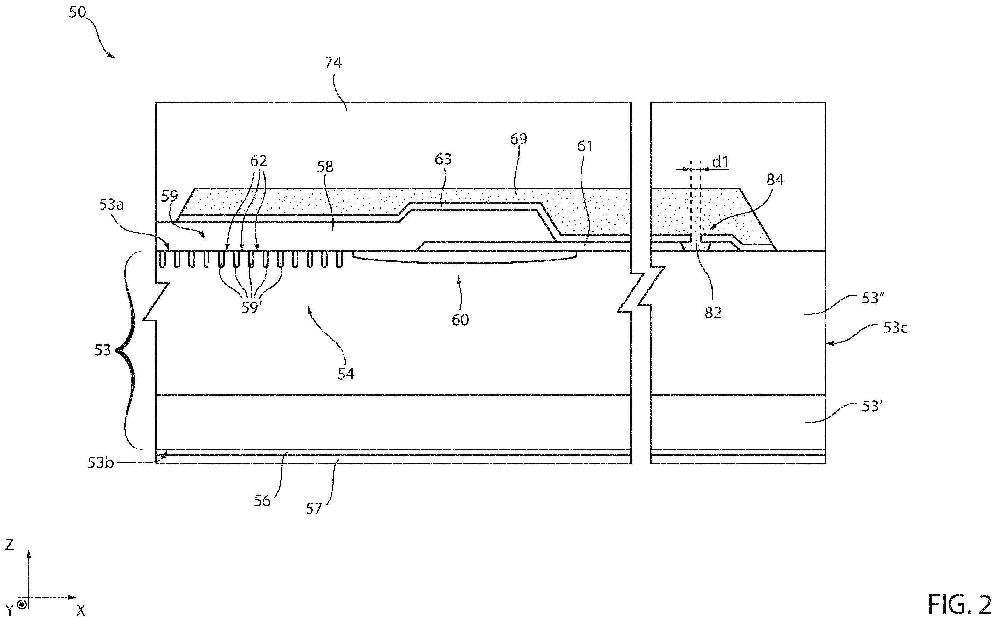

Figure 2 shows, in lateral cross-sectional view in the same (triaxial) cartesian reference system of axes X, Y, Z of Figure 1, an electronic device 50 according to an an example. In particular, the device 50 is a JBS diode, similar to what has been described with reference to Figure 1. However, the present disclosure is not limited to this device and finds application also in other types of electronic devices, in particular power devices, such as, for example, MOSFET, IGBT, MPS, Schottky diode, PN diode, PiN diode, etc.

The electronic device 50 comprises the elements described hereinafter, illustrated with reference to Figure 2.

A semiconductor body 53 (e.g., including a substrate 53' and, optionally, one or more epitaxial layers 53" grown thereon), of SiC of an N type or P type (in what follows non-limiting reference will be made only to an N type), is provided with a front surface 53a opposite to a rear surface 53b along the direction of the axis Z. The semiconductor body 53 includes, in the example illustrated in Figure 2, the substrate 53' on which the epitaxial layer 53" has been grown, having the function of drift layer of the electronic device 50, which are both of SiC of an N type (in particular 4H-SiC, however, other polytypes may be used such as, but not exclusively, 2H-SiC, 3C-SiC and 6H-SiC). For example, the substrate 53' has a concentration of dopants of an N type comprised between 1·10¹⁹ at/cm³ and 1·10²² at/cm³ and has a thickness, measured along the axis Z between the surfaces 53a and 53b, comprised between 300 µm and 450 µm, and in particular equal to approximately 360 µm. The drift layer 53" has a respective dopant concentration lower than the dopant concentration of the substrate and a thickness comprised, for example, between 5 and 15 µm.

An ohmic-contact layer 56 (for example, of nickel silicide) extends over the rear surface 53b, and a metallization 57, in this example a cathode metallization, for example, of Ti/NiV/Ag or Ti/NiV/Au, extends over the ohmic-contact region 56.

One or more doped regions 59' of a P type extend in the semiconductor body 53 (in particular, in the drift layer), facing the top surface 53a; each doped region 59' houses a respective ohmic contact (not shown and of a known type) such that each doped region 59' forms a respective junction-barrier (JB) element 59. An edge-termination region, or protection ring, 60, in particular a further doped region of a P type, extends in the drift layer, faces the top surface 53a, and surrounds completely (in plan view, in a plane XY defined by the axes X and Y) the JB elements 59. The edge-termination region 60 may be omitted.

An insulating layer 61 (of insulating or dielectric material, e.g., silicon oxide, or TEOS) extends over the top surface 53a so as to surround completely (in view in the plane XY) the JB elements 59 and to overlap partially the protection ring 60 (when present).

A metallization 58, in this example an anode metallization, for example, of Ti/AlSiCu or Ni/AlSiCu, extends over a portion of the top surface 53a delimited on the outside by the insulating layer 61 (i.e., at the JB elements 59/active area 54) and, partially, over the insulating layer 61.

A passivation layer 69 of polymeric material such as polyamide (e.g., PIX), extends over the anode metallization 58 and over the insulating layer 61.

An interface layer 63, here of silicon nitride (SiN), extends over the anode metallization 58 and over the insulating layer 61, and underneath the passivation layer 69. In other words, the interface layer 63 serves as interface between the passivation layer 69 and the underlying layers, here the metallization 58 and the insulating layer 61, and favours adhesion of the overlying passivation layer 69.

One or more Schottky diodes 62 are formed at the interface between the semiconductor body 53 and the anode metallization 58, laterally to the doped regions 59'. In particular, (semiconductor-metal) Schottky junctions are formed by portions of the semiconductor layer 53 in direct electrical contact with respective portions of the anode metallization 58.

Furthermore, each ohmic contact extending in the respective doped region 59' provides an electrical connection having a value of electrical resistivity lower than the value of electrical resistivity of the doped region 59' that houses it. The JB elements 59 are therefore P-i-N diodes.

The region of the electronic device 50 that includes the JB elements 59 and the Schottky diodes 62 (i.e., the region delimited by the protection ring 60) is an active area 54 of the electronic device 50.

Present outside the active area 54, i.e., beyond the edge-termination region 60, is a side surface 53c of the semiconductor body 53, for example, extending substantially orthogonal to the top surface 53a. The side surface 53c is formed following upon a step of dicing or singulation of a SiC wafer wherein a plurality of electronic devices 50 are obtained. The dicing step has the function of separating one electronic device 50 from another device 50 of the same wafer. Dicing is performed at a scribe line (not shown) of the SiC wafer from which the electronic device 50 is obtained. This scribe line surrounds at a distance, in the plane XY, the active region 54, the protection ring 60, and the insulating layer 61.

A protection layer 74, of a resin, such as, for example, bakelite, extends over the passivation layer 69, protecting the electronic device 50 when inserted in a package (not illustrated).

The passivation layer 69 has an anchoring element 82 that protrudes from the passivation layer 69 (in particular, along the direction of the axis Z) and extends in the insulating layer 61, until it reaches the top surface 53a of the semiconductor body 53. The anchoring element 82 anchors and fixes the passivation layer 69 to the insulating layer 61. The anchoring element 82 is integral to the passivation layer 69 and, in particular, is an extension of the passivation layer itself. The anchoring element 82 therefore extends from the passivation layer without interruptions and without interfaces and is of the same material as the passivation layer. In other words, the anchoring element 82 and the passivation layer 69 form a single or monolithic body.

The anchoring element 82 extends through an opening 84 made through the interface layer 63. The opening 84 has a shape chosen freely in the design stage, for example, a circular, oval, or polygonal shape, with a diameter d₁ of a few microns, for example, between 2 and 5 µm.

The anchoring element 82 is formed outside the active area 54, and in particular outside the edge-termination region 60; in other words, the anchoring element 82 is interposed between the edge-termination region 60 and the side surface 53c. In the case where the edge-termination region 60 were not present, the anchoring element 82 is formed outside the active area 54, i.e., between the active area 54 and the side surface 53c in an electrically passive region of the device.

The anchoring element 82 is patterned so as to fix the passivation layer 69 to the insulating layer 61 and is designed to prevent and/or impede delamination and/or detachment of the passivation layer 69.

In particular, the anchoring element 82 is housed and arranged slotted into a housing or cavity extending in the insulating layer 61 so as to couple the passivation layer 69 and the insulating layer 61 together and render them integral to one another. The cavity that houses the anchoring element 82 has a shape complementary to the shape of the anchoring element 82. In other words, the anchoring element 82 fills completely the cavity that houses it.

In an embodiment, the anchoring element 82 has dimensions, in the cross-sectional view of Figure 2 and measured along the axis X, that increase the greater the distance (along the axis Z) from the passivation layer 69.

In a different embodiment, the anchoring element 82 has a first dimension, in the cross-sectional view of Figure 2 and measured along the axis X, at the opening 84; the first dimension coincides with the aforementioned diameter d₁ of the opening 84. The anchoring element 82 moreover has a second dimension, in the cross-sectional view of Figure 2 and measured along the axis X, within the insulating layer 61. The second dimension is greater than the first dimension (for example, but not exclusively, twice as large, i.e., 2·d₁). Within the insulating layer 61, the anchoring element 82 may have any geometrical shape chosen in the design stage, with dimensions (once again considered in the cross-sectional view of Figure 2 and measured along the axis X) that are variable, but in any case larger than the aforementioned first dimension d₁ at the opening 84.

It is evident that, within the insulating layer 61, the anchoring element 82 may have, in addition or as an alternative to what has been said above with respect to the dimensions along X, a further dimension measured along the axis Y greater than a corresponding dimension (once again measured along the axis Y) of the opening 84.

In this way, since the anchoring element 82 extends underneath the opening 84 and has at least one dimension, in the plane XY, larger than a corresponding dimension, in the plane XY, of the opening 84, the anchoring element 82 has the purpose of fixing the passivation layer 69, which is thus constrained in its movements along the axis Z, therefore preventing any delamination or detachment.

In a further embodiment, within the insulating layer 61, the anchoring element 82 may have, locally, dimensions equal to or smaller than the aforementioned first dimension but, in any case, has at least one portion having a dimension larger than the aforementioned first dimension.

In the example of Figure 2, the portion of the anchoring element 82 that extends within the insulating layer 61 has (in the cross-sectional view and along the axis X) a trapezoidal shape, with the major side directly facing the interface layer 63 and the minor side in contact with the top surface 53a of the semiconductor body. In further embodiments, not illustrated, the portion of the anchoring element 82 that extends within the insulating layer 61 has (in the cross-sectional view and along the axis X) a rectangular or generically polygonal shape, or an oval shape, or a generically curved or curvilinear shape.

According to a further embodiment, the anchoring element 82 does not extend through the insulating layer 61 throughout the thickness of the latter, but terminates within the insulating layer 61, at a distance from the top surface 53a of the semiconductor body. Also in this case, the shape and dimensions may be chosen similarly to what has been described previously.

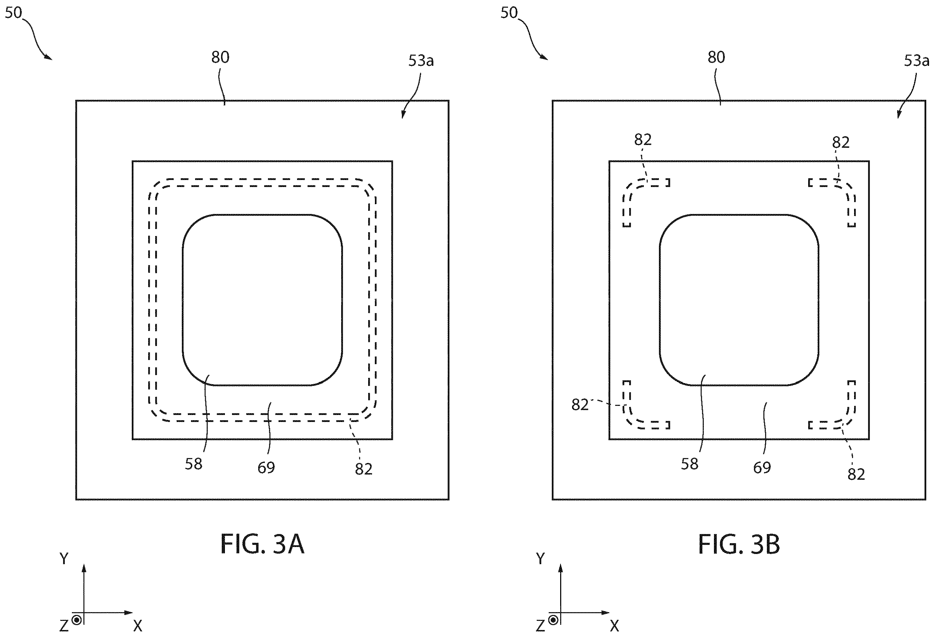

Figures 3A and 3B show schematically the electronic device 50 in top plan view (in the plane XY), according to respective embodiments.

With reference to Figure 3A, the anchoring element 82 extends in the plane XY so as to surround completely the anode metallization 58. In the view in the plane XY of Figure 3A, the anchoring element 82 is annular and defines a closed polygonal shape, and in greater detail a square shape with rounded corners (even though different shapes are also possible, such as a circular shape, a rectangular shape or a generically polygonal or irregular shape).

With reference to Figure 3B, the electronic device 50 comprises a plurality of anchoring elements (all of which are similar to the anchoring element 82 described previously and are therefore designated by the same reference number). The anchoring elements 82 extend at a distance from one another at the top surface 53a, at respective portions of the top surface 53a, at a distance from one another. For example, the view in the plane XY of Figure 3B shows four anchoring elements 82 arranged around the anode metallization 58 so as to be at equal angular distances apart with respect to the anode metallization 58, and in greater detail arranged at corners of an ideal square geometrical shape. Other arrangements are, however, possible.

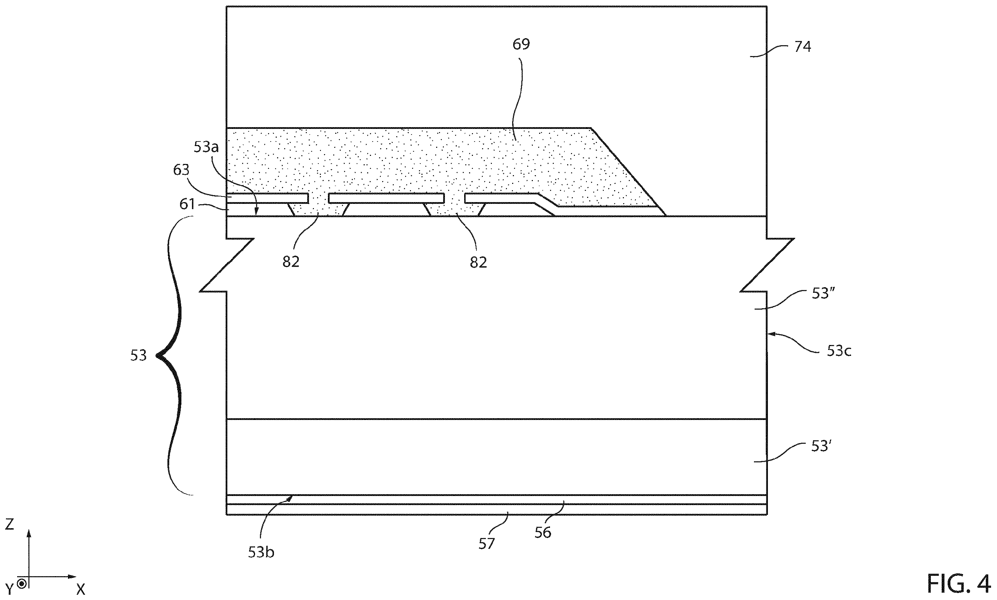

It is evident that, in an embodiment alternative to that of Figure 2, two or more anchoring elements 82 may be present set alongside one another. For example, as illustrated in Figure 4 (where only one portion of an electronic device similar to the electronic device 50 is represented), two anchoring elements 82 extend in the insulating layer 61 at a mutual distance apart from one another, along the axis X, equal to a few microns or a few tens of microns, for example between 5 µm and 20 µm. One, some or all of the anchoring elements 82 of this plurality of anchoring elements 82 extend within the insulating layer 61 throughout the thickness (along Z) of the latter, or only partially within the insulating layer 61, terminating in the insulating layer 61 without reaching the top surface 53a.

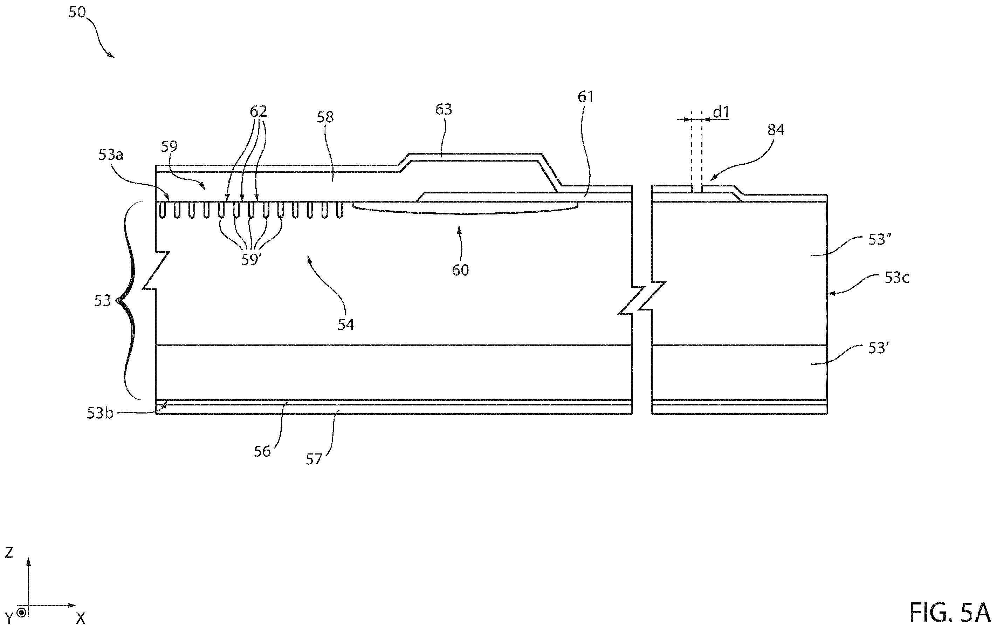

Steps for manufacturing the electronic device 50 of Figure 2 (similarly applicable to the embodiment of Figure 4) are described below, with reference to Figures 5A-5C and limitedly to the steps for formation of the anchoring element 82. Figures 5A-5C are represented in the same triaxial system as that of Figure 2.

With reference to Figure 5A, a wafer is provided that includes the SiC semiconductor body 53, following upon manufacturing steps designed to form elements of the electronic device 50 described previously (and not discussed here any further) and identified by the same reference numbers.

The interface layer 63 is selectively etched to form the opening 84. For this purpose, a photoresist mask is for example provided and, by lithographic and etching steps per se known, the opening 84 is formed having the shape, dimensions, and location discussed previously. The opening 84 extends through the interface layer 63 throughout the thickness of the latter, exposing a respective surface portion of the insulating layer 61.

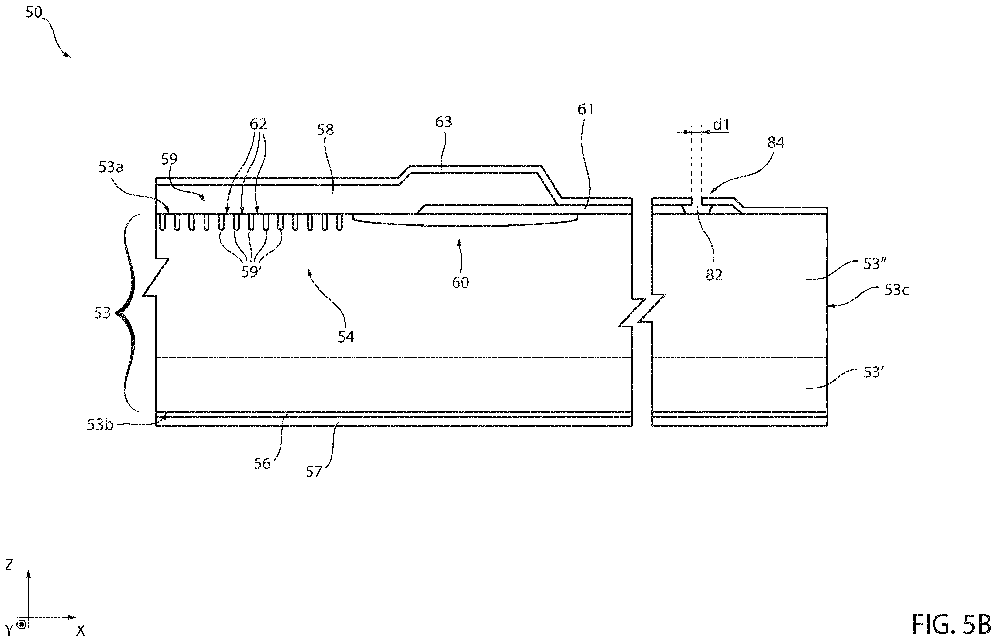

Next, Figure 5B, an etch of the insulating layer 61 is performed through the opening 84 formed previously. The etch is, for example, of a wet type and, if an etching chemistry is used that is selective with respect to the material of the insulating layer 61 (e.g., hydrofluoric acid in the case of silicon oxide), which therefore does not remove the interface layer 63, it is possible to carry out said etch in the absence of a further etching mask. In this case, it is the interface layer 63 that forms the etching mask. Otherwise, it is possible to use a mask similar to the one used for the step of formation of the opening 84.

Etching of the insulating layer 61 is of an isotropic type and, underneath the interface layer 63, removes the material of the insulating layer both vertically (along Z) and horizontally (in the plane XY). The etch is, for example, a timed etch and is interrupted according to the type of shape that it is desired to give to the anchoring element 82. In the embodiment of Figure 5B, etching proceeds until the top surface 53a of the semiconductor body 53 is exposed. As has been said, etching proceeds also laterally (along the axis X). A cavity 86 is thus formed in the insulating layer 61.

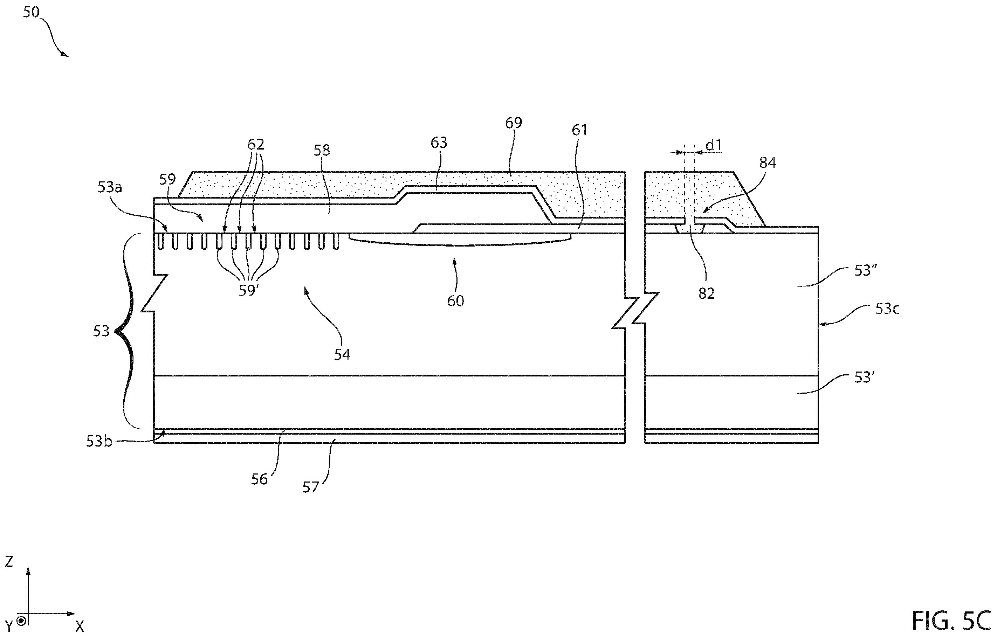

Then, Figure 5C, the passivation layer 69 is formed. The polymeric material, which is liquid or semi-liquid, is applied on the wafer and distributed through spinning on the interface layer 63. During this process, the polymeric material penetrates through the opening 84 and fills completely both the cavity 86 and the opening 84. Then a thermal process is carried out until the polymeric material hardens to form the passivation layer 69 (curing process) and, simultaneously, the anchoring element 82. The polymeric material is, for example, polyimide.

The manufacturing process then continues with subsequent steps to form further elements of the electronic device 50, not described here in detail (for example, the ohmic-contact layer 56 and the cathode metallization 57).

Figure 6 illustrates an electronic device 100 according to a first embodiment of the present invention. The electronic device 100 is represented in the same (triaxial) cartesian reference system of axes X, Y, Z of Figure 1 and Figure 2. In particular, the electronic device 100 is a JBS diode, similar to what has been described with reference to Figures 1 and 2. However, also in this case, the present invention is not limited to a JBS device and finds application also in other types of electronic devices, in particular power devices, such as MOSFET, IGBT, MPSs, Schottky diode, PN diode, PiN diode, etc.

Elements of the electronic device 100 common to the electronic device 50 of Figure 2 are designated by the same reference numbers and will not be described any further.

In particular, the electronic device 100 comprises, in addition to what has been described for the electronic device 50, a further insulating layer 102, in particular of a dielectric or insulating material, such as, for example, silicon oxide. In particular, the material of the insulating layer 102 is the same as the one used for the insulating layer 61. The insulating layer 102 has, for example, a thickness, along the axis Z, comprised between 0.5 and 2 µm.

The insulating layer 102 extends over the anode metallization 58 and the insulating layer 61 laterally to the anode metallization 58.

In the embodiment shown in Figure 6, the interface layer 63 extends over the insulating layer 102; the passivation layer 69 extends over, and in contact with, the interface layer 63.

According to the embodiment of Figure 6, the passivation layer 69 has, similarly to the embodiment of Figure 2, the anchoring element 82 that protrudes from the passivation layer 69 (in particular, along the direction of the axis Z). However, in this case, the anchoring element 82 extends completely within the insulating layer 102 (i.e., throughout the thickness, along Z, of the insulating layer 102) and only partially within the insulating layer 61 (terminating within the insulating layer 61), without reaching the top surface 53a of the semiconductor body 53. The anchoring element 82 anchors and fixes the passivation layer 69 both to the insulating layer 102 and to the insulating layer 61. The anchoring element 82 is integral to the passivation layer 69 and in particular is an extension of the passivation layer itself. The anchoring element 82 therefore extends from the passivation layer without interruptions and without interfaces and is of the same material as the passivation layer. In other words, the anchoring element 82 and the passivation layer 69 form a single or monolithic body.

The anchoring element 82 extends through the opening 84 made through the interface layer 63. The opening 84 has a shape chosen freely in the design stage, for example a circular, oval, or polygonal shape, with a diameter d₁ equal to a few microns, for example between 2 and 5 µm.

The anchoring element 82 is formed outside the active area 54, and in particular outside the edge-termination region 60 and at a distance from the anode metallization 58. In other words, the anchoring element 82 is interposed between the edge-termination region 60 and the side surface 53c. In the case where the edge-termination region 60 is not present, the anchoring element 82 is formed outside the active area 54, i.e., between the active area 54 and the side surface 53c in an electrically passive region of the device and at a distance from the anode metallization 58.

In particular, the anchoring element 82 is housed and arranged slotted into a housing or cavity extending in the insulating layer 102 and in the insulating layer 61 so as to couple the passivation layer 69 and the insulating layers 102 and 61 together and render them integral to one another. The cavity that houses the anchoring element 82 has a shape complementary to the shape of the anchoring element 82. In other words, the anchoring element 82 fills completely the cavity that houses it.

The anchoring element 82 has dimensions that have already been discussed with reference to Figure 2 and are not repeated here for brevity.

According to a further embodiment, not illustrated, the anchoring element 82 extends exclusively (in part or completely) in the insulating layer 102 (therefore terminating within the insulating layer 102 or at the interface between the insulating layer 102 and the underlying insulating layer 61). A time-based etching, configured to remove the exact thickness, along Z, of the insulating layer 102, can be used to achieve such result.

According to a further embodiment, not illustrated, the anchoring element 82 extends throughout the thickness of the insulating layer 102 and throughout the thickness of the insulating layer 61.

According to a further embodiment, not illustrated, a plurality of anchoring elements 82 may be present, similar to what has been described with reference to Figure 4. One, some or all of the anchoring elements 82 of this plurality of anchoring elements 82 extend exclusively within the insulating layer 102 (and not the insulating layer 61), or throughout the thickness of the insulating layer 102 and throughout the thickness of the insulating layer 61, or throughout the thickness of the insulating layer 102 and partially within the insulating layer 61.

In the embodiment of Figure 6, the insulating layer 102 has the function of forming a further interface between the interface layer 63 and the anode metallization 58, to obtain an electrical insulation at the anode metallization 58 in case of cracking of the interface layer 63.

According to a further aspect of the present disclosure, that is not shown in the drawings and is not part of the claimed invention, the device of Figure 6 may be modified in such a way that the interface layer 63 is absent and the passivation layer 69 extends over, and in contact with, the insulating layer 102.

Figures 7A-7D show steps for manufacturing the electronic device 100 of Figure 6 limitedly to the steps for formation of the anchoring element 82. Figures 7A-7D are represented in the same triaxial system of Figure 6.

With reference to Figure 7A, a wafer is provided that includes the SiC semiconductor body 53, following upon manufacturing steps designed to form elements of the electronic device 100 described previously (and not discussed any further herein) and identified by the same reference numbers.

With reference to Figure 7A, after having formed the insulating layer 61 and the anode metallization, a step of deposition of insulating or dielectric material is carried out to form the insulating layer 102. This step is carried out, for example, by a CVD process. The insulating layer 102 is formed on the entire surface of the wafer and in particular covers completely the anode metallization 50 and the insulating layer 61.

Then, after formation of the insulating layer 102, the interface layer 63 is formed, for example by deposition of a CVD type of silicon nitride. The interface layer 63 is formed on the entire surface of the wafer and in particular covers completely the insulating layer 102.

Then, Figure 7B, the interface layer 63 is selectively etched to form the opening 84. For this purpose, a photoresist mask is for example provided and, by lithographic and etching steps per se known, the opening 84 is formed having the shape, dimensions, and location discussed previously. The opening 84 extends through the interface layer 63 throughout the thickness of the latter, exposing a respective surface portion of the insulating layer 102.

Then, Figure 7C, an etch of the insulating layer 102 is carried out through the opening 84 formed previously. The etch is, for example, of a wet type and, if an etching chemistry is used that is selective with respect to the material of the insulating layer 102 (e.g., hydrofluoric acid in the case of silicon oxide), which therefore does not remove the interface layer 63, it is possible to carry out this etch in the absence of a mask. Otherwise, it is possible to use a mask similar to the one used for the step of formation of the opening 84.

Etching of the insulating layer 102 is of an isotropic type, and, underneath the interface layer 63, the material of the insulating layer 102 is removed both vertically (along Z) and horizontally (in the plane XY). The etch is, for example, a timed etch chosen according to the type of shape that it is desired to give to the anchoring element 82. In the embodiment of Figure 7C, etching proceeds until the insulating layer 102 is removed completely, and also proceeds with partial removal of the material of the underlying insulating layer 61. If the materials of the insulating layer 102 and of the insulating layer 61 can be etched using the same etching chemistry, removal of the portions of the insulating layer 102 and of the insulating layer 61 takes place during the same etching step; otherwise, after having removed the desired portion of the insulating layer 102, the etching chemistry changes to remove the desired portions of the insulating layer 61. As has been said, etching proceeds also laterally (along the axis X) both in the insulating layer 102 and in the insulating layer 61. A cavity 86 is thus formed in the insulating layers 102 and 61.

Then, Figure 7D, the passivation layer 69 is formed. The polymeric material, which is liquid or semi-liquid, is applied on the wafer and distributed through spinning on the interface layer 63. During this process, the polymeric material penetrates through the opening 84 and fills completely both the cavity 86 and the opening 84. A thermal process is then carried out so that the polymeric material hardens to form the passivation layer 69 (curing process) and, simultaneously, the anchoring element 82. The polymeric material is, for example, polyimide.

The manufacturing process then continues with subsequent steps to form further elements of the electronic device 100, here not described in detail (for example, the ohmic-contact layer 56 and the cathode metallization 57).

From an examination of the characteristics of the invention disclosure according to the present invention the advantages that it allows to obtain are evident.

In particular, the anchoring element 82 guarantees adhesion of the passivation layer 69, preventing phenomena of delamination. It is thus possible to obtain the passivation layer 69 using polymeric materials, thus guaranteeing high electrical performance of the electronic device 50, 100 (due to the high dielectric strength of the passivation layer 69) and eliminating, at the same time, structural problems linked to the possible detachment of the passivation layer 69 (e.g., following upon thermal cycles or use of the electronic device 50, 100).

Consequently, the risk of damage of the electronic device 50, 100 following upon electrical discharges between metallizations set at different potentials (e.g., between the equipotential-ring or EQR metallization and the anode metallization 58) is prevented, and therefore the reliability of the electronic device 50, 100 increases, in particular when it is subject to high thermal swings and operated in a reverse-biasing condition.

The manufacturing steps described with reference to Figures 5A-5C and 7A-7D make it possible to obtain the electronic device 50 and, respectively, 100 comprising the respective anchoring element 82 starting from a SiC wafer. The etch carried out with reference to Figures 5B-5C and 7B-7D is of an isotropic type, and this allows patterning of the cavity thus formed and, consequently, of the anchoring element 82 without limitations deriving from anisotropic etching processes or from the crystallographic orientation of the SiC wafer from which the electronic device 50, 100 is obtained.

Finally, it is clear that modifications and variations may be made to the invention disclosure described and illustrated herein, without thereby departing from the scope of the present invention, as defined in the annexed claims.

## Claims

1. A method of manufacturing an anchoring element (82) of a passivation layer (69) of an electronic device (50; 100), comprising the steps of:
forming, on a surface (53a) of a semiconductor body (53) of silicon carbide, a first insulating layer (61) of a first material;
forming, in part on the surface (53a) of the semiconductor body (53) and in part on the first insulating layer (61), a layer of metal material (58);forming a second insulating layer (102) on the first insulating layer (61) and on the layer of metal material (58), wherein the second insulating layer (102) is of the same first material as the first insulating layer (61) and forms, with the first insulating layer (61) laterally to the layer of metal material (58), an insulating multilayer structure (61, 102);
forming, on the second insulating layer (102), an interface layer (63) of a second material different from the first material;
removing selective portions of the interface layer (63) at a distance from the layer of metal material (58), to form an opening (84) throughout the interface layer (63), thus exposing a surface of the insulating multilayer structure (61, 102);
removing, through the opening (84), portions of the insulating multilayer structure (61, 102) to form a cavity (86) in the insulating multilayer structure (61, 102) at, and underneath, said opening (84), said cavity (86) having at least one dimension, in a direction parallel to said surface (53a), greater than a corresponding dimension (d1) of the opening (84); and
simultaneously providing, on the insulating multilayer structure (61, 102), in the opening (84) and in the cavity (86), passivation material thus forming the passivation layer (69) on the insulating multilayer structure (61, 102) and said anchoring element (82) in the opening (84) and in the cavity (86).

2. The manufacturing method according to claim 1, wherein the step of providing the passivation material comprises providing the passivation material in liquid or semi-liquid form, so that the passivation material fills the cavity (86).

3. The manufacturing method according to claim 1 or 2, wherein the step of providing the passivation material comprises carrying out a step of spinning of the passivation material.

4. The manufacturing method according to claim 2, or according to claim 3 when depending upon claim 2, further comprising the step of solidifying, or curing, the passivation material, so that the anchoring element (82) and the passivation layer (69) form a single body or monolithic body.

5. The manufacturing method according to anyone of the preceding claims, wherein removing selective portions of the insulating multilayer structure (61, 102) comprises carrying out an isotropic etching of at least a portion of the insulating multilayer structure (61, 102).

6. The manufacturing method according to anyone of the preceding claims, wherein removing selective portions of the insulating multilayer structure (61, 102) through the opening (84) comprises carry out a time-based etching of the second insulating layer (102), reaching an interface between the second insulating layer (102) and the first insulating layer (61).

7. The manufacturing method according to according to claim 6, wherein the second insulating layer (102) has a thickness, said time-based etching being designed to remove the second insulating layer (102) for said thickness in correspondence of the opening (84).

8. The manufacturing method according to anyone of claims 1-5, wherein removing selective portions of the insulating multilayer structure (61, 102) through the opening (84) comprises carry out an etching of the second insulating layer (102) and of part of the first insulating layer (61), terminating within the first insulating layer (61),
the step of forming the anchoring element (82) including constraining the anchoring element (82) underneath the interface layer (63) and within the first insulating layer (61).

9. The manufacturing method according to anyone of claims 1-5, wherein removing selective portions of the insulating multilayer structure (61, 102) through the opening (84) comprises carry out an etching of the second insulating layer (102) and of the first insulating layer (61), reaching the surface (53a) of the semiconductor body (53).

10. The manufacturing method according to anyone of the preceding claims, wherein the interface layer (63) is configured to favour adhesion of the passivation layer (69) with the insulating multilayer structure (61, 102).

11. The manufacturing method according to anyone of the preceding claims, wherein forming the opening (84) comprises forming an etching mask for the insulating multilayer structure (61, 102);
the step of removing, through the opening (84), selective portions of the insulating multilayer structure (61, 102) including carrying out a wet etching of the insulating multilayer structure (61, 102).

12. The manufacturing method according to anyone of the preceding claims, wherein said cavity (86) has a volume greater than the volume of the opening (84).

13. The manufacturing method according to anyone of the preceding claims, wherein the passivation material (69) comprises polymeric material.

14. The manufacturing method according to anyone of the preceding claims, wherein the material of the interface layer is silicon nitride.

15. The manufacturing method according to anyone of the preceding claims, wherein the anchoring element (82) is formed outside the active area of the electronic device, at a distance from the layer of metal material (58).

16. An electronic device (50; 100), comprising:
a semiconductor body (53) of silicon carbide;
a first insulating layer (61), of a first material, on a surface (53a) of the semiconductor body (53);
a layer of metal material (58) extending in part on the surface (53a) of the semiconductor body (53) and in part on the first insulating layer (61);
a second insulating layer (102) on the first insulating layer (61) and on the layer of metal material (58), of the same first material as the first insulating layer (61), the first and second insulating layers forming, laterally to the layer of metal material (58), an insulating multilayer structure (61, 102);
an interface layer (63) on the second insulating layer (102), the interface layer (63) being of a second material different from the first material;
a passivation layer (69) on the interface layer (63); and
an anchoring element (82) that protrudes from the passivation layer (69) towards the insulating multilayer structure (61, 102) and extends completely through an opening (84) of the interface layer (63) and terminates within the insulating multilayer structure (61, 102), said anchoring element (82) having at least one dimension, in a direction parallel to said surface (53a), greater than a corresponding dimension (d1) of the opening (84).

17. The electronic device according to claim 16, wherein the anchoring element (82) and the passivation layer (69) form a single body, or monolithic body.

18. The electronic device according to claim 16 or 17, wherein the anchoring element (82) is configured to constrain the passivation layer (69) underneath the interface layer (63) and within one among the first insulating layer (61) and the second insulating layer (102).

19. The electronic device according to anyone of claims 16 to 18, wherein the anchoring element (82) comprises:
a first portion extending in the insulating multilayer structure at a first distance from the surface (53a) and having, in a direction parallel to a first axis (X; Y) parallel to the surface (53a), a maximum dimension having a first value (d₁); and
a second portion extending in the insulating multilayer structure in structural continuation of the first portion and having, in a direction parallel to the first axis (X; Y), a respective maximum dimension having a second value greater than the first value (d₁).

20. The electronic device according to anyone of claims 16 to 19, wherein the passivation material (69) comprises polymeric material.

21. The electronic device according to anyone of claims 16 to 20, wherein the material of the interface layer (63) is silicon nitride.

22. The electronic device according to anyone of claims 16 to 21, wherein the anchoring element (82) extends outside the active area of the electronic device (50; 100).

23. The electronic device according to anyone of claims 16 to 22, chosen in the group comprising: a Schottky diode, a PiN diode, a PN diode, an MPS device, a JBS diode, a MOSFET, an IGBT, or a power device.

## Patentansprüche

1. Verfahren zur Herstellung eines Verankerungselements (82) einer Passivierungsschicht (69) einer elektronischen Vorrichtung (50; 100), das die folgenden Schritte umfasst:
Bilden einer ersten Isolierschicht (61) aus einem ersten Material auf einer Oberfläche (53a) eines Halbleiterkörpers (53) aus Siliziumkarbid;
Bilden, teilweise auf der Oberfläche (53a) des Halbleiterkörpers (53) und teilweise auf der ersten Isolierschicht (61), einer Schicht aus Metallmaterial (58);
Bilden einer zweiten Isolierschicht (102) auf der ersten Isolierschicht (61) und auf der Schicht aus Metallmaterial (58), wobei die zweite Isolierschicht (102) aus demselben ersten Material wie die erste Isolierschicht (61) besteht und mit der ersten Isolierschicht (61) seitlich der Schicht aus Metallmaterial (58) eine isolierende Mehrschichtstruktur (61, 102) bildet;
Bilden einer Schnittstellenschicht (63) aus einem zweiten Material, das sich vom ersten Material unterscheidet, auf der zweiten Isolierschicht (102);
Entfernen selektiver Abschnitte der Schnittstellenschicht (63) in einem Abstand von der Schicht aus Metallmaterial (58), um eine Öffnung (84) in der gesamten Schnittstellenschicht (63) zu bilden, wodurch eine Oberfläche der isolierenden Mehrschichtstruktur (61, 102) freigelegt wird;
Entfernen von Abschnitten der isolierenden Mehrschichtstruktur (61, 102) durch die Öffnung (84), um einen Hohlraum (86) in der isolierenden Mehrschichtstruktur (61, 102) an und unterhalb der Öffnung (84) zu bilden, wobei der Hohlraum (86) mindestens eine Abmessung in einer Richtung parallel zur Oberfläche (53a) aufweist, die größer ist als eine entsprechende Abmessung (d1) der Öffnung (84); und
gleichzeitiges Bereitstellen von Passivierungsmaterial auf der isolierenden Mehrschichtstruktur (61, 102), in der Öffnung (84) und in dem Hohlraum (86), wodurch die Passivierungsschicht (69) auf der isolierenden Mehrschichtstruktur (61, 102) und das Verankerungselement (82) in der Öffnung (84) und in dem Hohlraum (86) gebildet werden.

2. Herstellungsverfahren nach Anspruch 1, wobei der Schritt des Bereitstellens des Passivierungsmaterials das Bereitstellen des Passivierungsmaterials in flüssiger oder halbflüssiger Form umfasst, so dass das Passivierungsmaterial den Hohlraum (86) füllt.

3. Herstellungsverfahren nach Anspruch 1 oder 2, wobei der Schritt des Bereitstellens des Passivierungsmaterials das Durchführen eines Schritts des Spinnens des Passivierungsmaterials umfasst.

4. Herstellungsverfahren nach Anspruch 2 oder nach Anspruch 3, wenn abhängig von Anspruch 2, ferner umfassend den Schritt des Verfestigens oder Aushärtens des Passivierungsmaterials, so dass das Verankerungselement (82) und die Passivierungsschicht (69) einen einzigen Körper oder einen monolithischen Körper bilden.

5. Herstellungsverfahren nach einem der vorhergehenden Ansprüche, wobei das Entfernen selektiver Abschnitte der isolierenden Mehrschichtstruktur (61, 102) das Durchführen eines isotropen Ätzens von mindestens einem Abschnitt der isolierenden Mehrschichtstruktur (61, 102) umfasst.

6. Herstellungsverfahren nach einem der vorhergehenden Ansprüche, wobei das Entfernen selektiver Abschnitte der isolierenden Mehrschichtstruktur (61, 102) durch die Öffnung (84) ein zeitbasiertes Ätzen der zweiten Isolierschicht (102) umfasst, wobei eine Schnittstelle zwischen der zweiten Isolierschicht (102) und der ersten Isolierschicht (61) erreicht wird.

7. Herstellungsverfahren nach Anspruch 6, wobei die zweite Isolierschicht (102) eine Dicke aufweist, wobei das zeitbasierte Ätzen so ausgelegt ist, dass die zweite Isolierschicht (102) für diese Dicke entsprechend der Öffnung (84) entfernt wird.

8. Herstellungsverfahren nach einem der Ansprüche 1 bis 5, wobei das Entfernen selektiver Abschnitte der isolierenden Mehrschichtstruktur (61, 102) durch die Öffnung (84) das Durchführen eines Ätzens der zweiten Isolierschicht (102) und eines Teils der ersten Isolierschicht (61) umfasst, das innerhalb der ersten Isolierschicht (61) endet,
wobei der Schritt des Bildens des Verankerungselements (82) das Festhalten des Verankerungselements (82) unterhalb der Schnittstellenschicht (63) und innerhalb der ersten Isolierschicht (61) enthält.

9. Herstellungsverfahren nach einem der Ansprüche 1 bis 5, wobei das Entfernen selektiver Abschnitte der isolierenden Mehrschichtstruktur (61, 102) durch die Öffnung (84) ein Ätzen der zweiten Isolierschicht (102) und der ersten Isolierschicht (61) umfasst, das die Oberfläche (53a) des Halbleiterkörpers (53) erreicht.

10. Herstellungsverfahren nach einem der vorhergehenden Ansprüche, wobei die Schnittstellenschicht (63) so eingerichtet ist, dass sie die Haftung der Passivierungsschicht (69) mit der isolierenden Mehrschichtstruktur (61, 102) begünstigt.

11. Herstellungsverfahren nach einem der vorhergehenden Ansprüche, wobei das Bilden der Öffnung (84) das Bilden einer Ätzmaske für die isolierende Mehrschichtstruktur (61, 102) umfasst;
wobei der Schritt des Entfernens selektiver Abschnitte der isolierenden Mehrschichtstruktur (61, 102) durch die Öffnung (84) das Durchführen eines Nassätzens der isolierenden Mehrschichtstruktur (61, 102) enthält.

12. Herstellungsverfahren nach einem der vorhergehenden Ansprüche, wobei der Hohlraum (86) ein Volumen aufweist, das größer ist als das Volumen der Öffnung (84).

13. Herstellungsverfahren nach einem der vorhergehenden Ansprüche, wobei das Passivierungsmaterial (69) polymeres Material umfasst.

14. Herstellungsverfahren nach einem der vorhergehenden Ansprüche, wobei das Material der Schnittstellenschicht Siliziumnitrid ist.

15. Herstellungsverfahren nach einem der vorhergehenden Ansprüche, wobei das Verankerungselement (82) außerhalb des aktiven Bereichs der elektronischen Vorrichtung in einem Abstand von der Schicht aus Metallmaterial (58) ausgebildet ist.

16. Elektronische Vorrichtung (50; 100), umfassend:
einen Halbleiterkörper (53) aus Siliziumkarbid;
eine erste Isolierschicht (61) aus einem ersten Material auf einer Oberfläche (53a) des Halbleiterkörpers (53);
eine Schicht aus Metallmaterial (58), die sich teilweise auf der Oberfläche (53a) des Halbleiterkörpers (53) und teilweise auf der ersten Isolierschicht (61) erstreckt;
eine zweite Isolierschicht (102) auf der ersten Isolierschicht (61) und auf der Schicht aus Metallmaterial (58) aus demselben ersten Material wie die erste Isolierschicht (61), wobei die erste und die zweite Isolierschicht seitlich der Schicht aus Metallmaterial (58) eine isolierende Mehrschichtstruktur (61, 102) bilden;
eine Schnittstellenschicht (63) auf der zweiten Isolierschicht (102), wobei die Schnittstellenschicht (63) aus einem zweiten Material besteht, das sich vom ersten Material unterscheidet;
eine Passivierungsschicht (69) auf der Schnittstellenschicht (63); und
ein Verankerungselement (82), das aus der Passivierungsschicht (69) in Richtung der isolierenden Mehrschichtstruktur (61, 102) herausragt und sich vollständig durch eine Öffnung (84) der Schnittstellenschicht (63) erstreckt und innerhalb der isolierenden Mehrschichtstruktur (61, 102) endet, wobei das Verankerungselement (82) mindestens eine Abmessung aufweist, die in einer Richtung parallel zu der Oberfläche (53a) größer ist als eine entsprechende Abmessung (d1) der Öffnung (84).

17. Elektronische Vorrichtung nach Anspruch 16, wobei das Verankerungselement (82) und die Passivierungsschicht (69) einen einzigen Körper oder einen monolithischen Körper bilden.

18. Elektronische Vorrichtung nach Anspruch 16 oder 17, wobei das Verankerungselement (82) so eingerichtet ist, dass es die Passivierungsschicht (69) unterhalb der Schnittstellenschicht (63) und innerhalb der ersten Isolierschicht (61) oder der zweiten Isolierschicht (102) festhält.

19. Elektronische Vorrichtung nach einem der Ansprüche 16 bis 18, wobei das Verankerungselement (82) Folgendes umfasst:
einen ersten Abschnitt, der sich in der isolierenden Mehrschichtstruktur in einem ersten Abstand von der Oberfläche (53a) erstreckt und in einer Richtung parallel zu einer ersten Achse (X; Y) parallel zur Oberfläche (53a) eine Maximalabmessung aufweist, die einen ersten Wert (d₁) aufweist; und
einen zweiten Abschnitt, der sich in der isolierenden Mehrschichtstruktur in struktureller Fortsetzung des ersten Abschnitts erstreckt und in einer Richtung parallel zur ersten Achse (X; Y) eine jeweilige Maximalabmessung aufweist, die einen zweiten Wert aufweist, der größer ist als der erste Wert (d₁).

20. Elektronische Vorrichtung nach einem der Ansprüche 16 bis 19, wobei das Passivierungsmaterial (69) polymeres Material umfasst.

21. Elektronische Vorrichtung nach einem der Ansprüche 16 bis 20, wobei das Material der Schnittstellenschicht (63) Siliziumnitrid ist.

22. Elektronische Vorrichtung nach einem der Ansprüche 16 bis 21, wobei sich das Verankerungselement (82) außerhalb des aktiven Bereichs der elektronischen Vorrichtung (50; 100) erstreckt.

23. Elektronische Vorrichtung nach einem der Ansprüche 16 bis 22, die aus der Gruppe ausgewählt ist, die Folgendes umfasst: eine Schottky-Diode, eine PiN-Diode, eine PN-Diode, eine MPS-Vorrichtung, eine JBS-Diode, einen MOSFET, einen IGBT oder eine Leistungsvorrichtung.

## Revendications

1. Procédé de fabrication d'un élément d'ancrage (82) d'une couche de passivation (69) d'un dispositif électronique (50 ; 100), comprenant les étapes suivantes :
former, sur une surface (53a) d'un corps semiconducteur (53) en carbure de silicium, une première couche isolante (61) faite d'un premier matériau ;
former, en partie sur la surface (53a) du corps semiconducteur (53) et en partie sur la première couche isolante (61), une couche de matériau métallique (58) ; former une deuxième couche isolante (102) sur la première couche isolante (61) et sur la couche de matériau métallique (58), dans lequel la deuxième couche isolante (102) est faite du même premier matériau que la première couche isolante (61) et forme, avec la première couche isolante (61) latéralement à la couche de matériau métallique (58), une structure multicouche isolante (61, 102) ;
former, sur la deuxième couche isolante (102), une couche d'interface (63) faite d'un deuxième matériau, différent du premier matériau ;
supprimer des parties sélectives de la couche d'interface (63) à distance de la couche de matériau métallique (58), pour former une ouverture (84) dans la couche d'interface (63), exposant ainsi une surface de la structure multicouche isolante (61, 102) ;
supprimer, à travers l'ouverture (84), des parties de la structure multicouche isolante (61, 102) pour former une cavité (86) dans la structure multicouche isolante (61, 102) au niveau de, et sous ladite ouverture (84), ladite cavité (86) ayant au moins une dimension, dans une direction parallèle à ladite surface (53a), plus grande qu'une dimension correspondante (d1) de l'ouverture (84) ; et
fournir simultanément, sur la structure multicouche isolante (61, 102), dans l'ouverture (84) et dans la cavité (86), un matériau de passivation formant ainsi la couche de passivation (69) sur la structure multicouche isolante (61, 102) et ledit élément d'ancrage (82) dans l'ouverture (84) et dans la cavité (86).

2. Procédé de fabrication selon la revendication 1, dans lequel l'étape de fourniture du matériau de passivation comprend le fait de fournir le matériau de passivation sous une forme liquide ou semi-liquide, de sorte que le matériau de passivation remplit la cavité (86).

3. Procédé de fabrication selon la revendication 1 ou 2, dans lequel l'étape de fourniture du matériau de passivation comprend l'exécution d'une étape d'application centrifuge du matériau de passivation.

4. Procédé de fabrication selon la revendication 2, ou selon la revendication 3 lorsqu'elle dépend de la revendication 2, comprenant en outre l'étape consistant à solidifier, ou durcir, le matériau de passivation, de sorte que l'élément d'ancrage (82) et la couche de passivation (69) forment un corps simple ou corps monolithique.

5. Procédé de fabrication selon l'une quelconque des revendications précédentes, dans lequel la suppression de parties sélectives de la structure multicouche isolante (61, 102) comprend la réalisation d'une gravure isotrope d'au moins une partie de la structure multicouche isolante (61, 102).

6. Procédé de fabrication selon l'une quelconque des revendications précédentes, dans lequel la suppression de parties sélectives de la structure multicouche isolante (61, 102) à travers l'ouverture (84) comprend la réalisation d'une gravure basée sur le temps de la deuxième couche isolante (102), atteignant une interface entre la deuxième couche isolante (102) et la première couche isolante (61).

7. Procédé de fabrication selon la revendication 6, dans lequel la deuxième couche isolante (102) a une épaisseur, ladite gravure basée sur le temps étant conçue pour supprimer la deuxième couche isolante (102) pour ladite épaisseur en correspondance avec l'ouverture (84).

8. Procédé de fabrication selon l'une quelconque des revendications 1 à 5, dans lequel la suppression de parties sélectives de la structure multicouche isolante (61, 102) à travers l'ouverture (84) comprend la réalisation d'une gravure de la deuxième couche isolante (102) et d'une partie de la première couche isolante (61), se terminant dans la première couche isolante (61),
l'étape de formation de l'élément d'ancrage (82) comprenant le fait d'immobiliser l'élément d'ancrage (82) sous la couche d'interface (63) et dans la première couche isolante (61).

9. Procédé de fabrication selon l'une quelconque des revendications 1 à 5, dans lequel la suppression de parties sélectives de la structure multicouche isolante (61, 102) à travers l'ouverture (84) comprend la réalisation d'une gravure de la deuxième couche isolante (102) et de la première couche isolante (61), atteignant la surface (53a) du corps semiconducteur (53).

10. Procédé de fabrication selon l'une quelconque des revendications précédentes, dans lequel la couche d'interface (63) est configurée pour favoriser l'adhésion de la couche de passivation (69) avec la structure multicouche isolante (61, 102).

11. Procédé de fabrication selon l'une quelconque des revendications précédentes, dans lequel la formation de l'ouverture (84) comprend la formation d'un masque de gravure pour la structure multicouche isolante (61, 102) ;
l'étape de suppression, à travers l'ouverture (84), de parties sélectives de la structure multicouche isolante (61, 102) comprenant la réalisation d'une gravure humide de la structure multicouche isolante (61, 102).

12. Procédé de fabrication selon l'une quelconque des revendications précédentes, dans lequel ladite cavité (86) a un volume supérieur au volume de l'ouverture (84).

13. Procédé de fabrication selon l'une quelconque des revendications précédentes, dans lequel le matériau de passivation (69) comprend un matériau polymère.

14. Procédé de fabrication selon l'une quelconque des revendications précédentes, dans lequel le matériau de la couche d'interface est du nitrure de silicium.

15. Procédé de fabrication selon l'une quelconque des revendications précédentes, dans lequel l'élément d'ancrage (82) est formé à l'extérieur de la région active du dispositif électronique, à distance de la couche de matériau métallique (58).

16. Dispositif électronique (50 ; 100) comprenant :
un corps semiconducteur (53) en carbure de silicium ;
une première couche isolante (61), faite d'un premier matériau, sur une surface (53a) du corps semiconducteur (53) ;
une couche de matériau métallique (58) s'étendant en partie sur la surface (53a) du corps semiconducteur (53) et en partie sur la première couche isolante (61) ;
une deuxième couche isolante (102) sur la première couche isolante (61) et sur la couche de matériau métallique (58), faite du même premier matériau que la première couche isolante (61), les première et deuxième couches isolantes formant latéralement à la couche de matériau métallique (58), une structure multicouche isolante (61, 102) ;
une couche d'interface (63) sur la deuxième couche isolante (102), la couche d'interface (63) étant faite d'un deuxième matériau, différent du premier matériau ;
une couche de passivation (69) sur la couche d'interface (63) ; et
un élément d'ancrage (82) qui fait saillie depuis la couche de passivation (69) vers la structure multicouche isolante (61, 102) et s'étend complètement dans une ouverture (84) de la couche d'interface (63) et se termine dans la structure multicouche isolante (61, 102), ledit élément d'ancrage (82) ayant au moins une dimension, dans une direction parallèle à ladite surface (53a), plus grande qu'une dimension correspondante (d1) de l'ouverture (84).

17. Dispositif électronique selon la revendication 16, dans lequel l'élément d'ancrage (82) et la couche de passivation (69) forment un corps simple ou corps monolithique.

18. Dispositif électronique selon la revendication 16 ou 17, dans lequel l'élément d'ancrage (82) est configuré pour immobiliser la couche de passivation (69) sous la couche d'interface (63) et dans une couche parmi la première couche isolante (61) et la deuxième couche isolante (102).

19. Dispositif électronique selon l'une quelconque des revendications 16 à 18, dans lequel l'élément d'ancrage (82) comprend :
une première partie s'étendant dans la structure multicouche isolante à une première distance de la surface (53a) et ayant, dans une direction parallèle à un premier axe (X ; Y) parallèle à la surface (53a), une dimension maximale ayant une première valeur (d₁) ; et
une deuxième partie s'étendant dans la structure multicouche isolante dans la continuité structurelle de la première partie et ayant, dans une direction parallèle au premier axe (X ; Y), une dimension maximale respective ayant une deuxième valeur, supérieure à la première valeur (d₁).

20. Dispositif électronique selon l'une quelconque des revendications 16 à 19, dans lequel le matériau de passivation (69) comprend un matériau polymère.

21. Dispositif électronique selon l'une quelconque des revendications 16 à 20, dans lequel le matériau de la couche d'interface (63) est du nitrure de silicium.

22. Dispositif électronique selon l'une quelconque des revendications 16 à 21, dans lequel l'élément d'ancrage (82) s'étend à l'extérieur de la région active du dispositif électronique (50 ; 100).

23. Dispositif électronique selon l'une quelconque des revendications 16 à 22, choisi dans le groupe comprenant : une diode Schottky, une diode PIN, une diode PN, un dispositif MPS, une diode JBS, un transistor MOSFET, un transistor IGBT ou un dispositif de puissance.
